# FASCICULE DE BREVET EUROPEEN

(11) **EP 3 049 817 B1**
(45) Date de publication et mention de la délivrance du brevet: **12.08.2020**
(21) Numéro de dépôt: 14784287.6
(22) Date de dépôt: 12.09.2014
(51) Int. Cl.: G01R 33/34, G01R 33/36, G01R 33/3415

(54) **SYSTEME D'ANTENNE RADIOFREQUENCE FONDE SUR L'HYBRIDATION DE MODE POUR DISPOSITIF DE RESONANCE MAGNETIQUE NUCLEAIRE**
HOCHFREQUENZANTENNENSYSTEM AUF BASIS EINER MODUSHYBRIDISIERUNG FÜR EINE KERNSPINRESONANZVORRICHTUNG
RADIO-FREQUENCY ANTENNA SYSTEM BASED ON MODE HYBRIDISATION FOR A NUCLEAR MAGNETIC RESONANCE DEVICE

(30) Priorité: 27.09.2013 FR 1359369
(43) Date de publication de la demande: 03.08.2016
(73) Titulaire: Centre National de la Recherche Scientifique (C.N.R.S.), 75794 Paris Cedex 16 (FR)
(72) Inventeur: ABDEDDAIM, Mohamed Redha, F-13008 Marseille (FR); JOUVAUD, Camille, F-75015 Paris (FR); LARRAT, Benoît, F-75013 Paris (FR); DEROSNY, Julien, F-94130 Nogent sur Marne (FR); TANTER, Mickael, F-92220 Bagneux (FR); FINK, Mathias, F-92190 Meudon (FR)
(74) Mandataire: Lavoix
(86) Numéro de dépôt international: PCT/FR2014/052272
(87) Numéro de publication internationale: WO 2015/044554

(56) Documents cités:
- FR-A1- 2 681 432
- US-A- 5 998 999
- US-A1- 2008 284 436
- ALEXANDER NOVIKOV: "Advanced theory of driven birdcage resonator with losses for biomedical magnetic resonance imaging and spectroscopy", MAGNETIC RESONANCE IMAGING, ELSEVIER SCIENCE, TARRYTOWN, NY, US, vol. 29, no. 2, 1 août 2010 (2010-08-01), pages 260-271, XP028138164, ISSN: 0730-725X, DOI: 10.1016/J.MRI.2010.08.001 [extrait le 2010-08-06]
- STUART CROZIER ET AL: "Incorporating phase retardation effects into radiofrequency resonator models: application to magnetic resonance microscopy", MEASUREMENT SCIENCE AND TECHNOLOGY, IOP, BRISTOL, GB, vol. 11, no. 3, 1 mars 2000 (2000-03-01), pages 221-226, XP020062881, ISSN: 0957-0233, DOI: 10.1088/0957-0233/11/3/308

## Description

La présente invention est relative aux systèmes d'antennes radiofréquence, notamment pour l'imagerie et la spectroscopie par résonance magnétique nucléaire, et aux dispositifs comportant de tels systèmes.

Plus particulièrement, l'invention se rapporte à un système d'antenne radiofréquence comprenant au moins un émetteur et/ou récepteur radiofréquence relié à un dispositif de commande d'émission et/ou réception adapté pour faire émettre et/ou recevoir par ladite antenne radiofréquence, des ondes radiofréquence à une fréquence radio ω0 dans un volume donné, et des résonateurs hybridés entre eux et ayant une fréquence de résonance ω' proche de ω0, hybridés électromagnétiquement entre eux, couplés à l'émetteur et/ou récepteur radiofréquence et isolés électriquement les uns des autres et de l'émetteur et/ou récepteur radiofréquence.

La « cage à oiseau » (« Birdcage ») telle que décrite dans le document de Cecil E. Hayes « the development of the birdcage resonator : a historical perspective » est un exemple de tel système d'antenne radiofréquence comportant un système de résonateurs connectés entre eux par l'intermédiaire de composants passifs et à l'émetteur et/ou récepteur radiofréquence. Il y a un nombre pair de tiges équi-réparties. Le rapport signal sur bruit du dispositif d'imagerie IRM est augmenté par rapport à une antenne simple telle qu'une boucle, la profondeur de pénétration est plus importante et la zone d'éclairement longitudinale est augmentée.

Dans un tel système d'antenne radiofréquence la connexion entre les tiges constitue un encombrement important autour de l'objet imagé. De plus le champ magnétique généré par un tel système d'antenne radiofréquence n'est pas parfaitement homogène en particulier à haut champ magnétique supérieur ou égal à 3T.

La présente invention a notamment pour but de pallier ces inconvénients.

A cet effet, selon l'invention, un système d'antenne radiofréquence pour un dispositif de résonance magnétique nucléaire tel que défini par la revendication indépendante 1 est caractérisé en ce que les résonateurs sont hybridés électromagnétiquement entre eux, couplés à l'émetteur et/ou récepteur radiofréquence et isolés électriquement les uns des autres et de l'émetteur et/ou récepteur radiofréquence.

Grâce à ces dispositions, l'encombrement autour du sujet est plus faible, facilitant l'utilisation du dispositif de résonance magnétique nucléaire. Le champ magnétique est rendu potentiellement plus homogène par hybridation de modes, en particulier à haut champ supérieur ou égal à 3T.
Parmi les autres avantages liés à l'invention, le système d'antenne radiofréquence peut être accordé ou désaccordé mécaniquement, en modifiant la géométrie et l'agencement des résonateurs hybridés électromagnétiquement notamment.

Dans des modes de réalisation préférés du système d'antenne selon l'invention, on peut éventuellement avoir recours en outre à l'une et/ou à l'autre des dispositions suivantes :
- les résonateurs sont au nombre de N et présentent N modes hybridés, le système d'antenne radiofréquence comportant en outre des moyens d'excitation de mode pour exciter sélectivement lesdits modes hybridés ;
- lesdits moyens d'excitation de mode sont adaptés pour exciter simultanément plusieurs modes hybridés ;
- les résonateurs comportent des résonateurs qui présentent au moins une résonance principalement excitée par le champ électrique ;
- les résonateurs qui présentent au moins une résonance principalement excitée par le champ électrique sont des tiges résonantes, parallèles disposées autour du volume donné et réalisées en un matériau amagnétique et conducteur de l'électricité ;
- les tiges sont agencées à égale distance d'un axe central ;
- l'émetteur et/ou récepteur radiofréquence comporte une antenne radiofréquence choisie parmi une boucle et un dipôle électrique non adapté ;
- l'émetteur et/ou récepteur radiofréquence comporte plusieurs antennes radiofréquences ;
- le système comporte en outre un élément solide diélectrique d'indice élevé disposé au moins partiellement entre les résonateurs ;
- les résonateurs ont une longueur réglable, comprenant en outre au moins un dispositif interne pour régler la longueur des tiges, la fréquence de résonance des résonateurs étant fonction de ladite longueur ;
- le système comporte en outre un dispositif de déplacement pour déplacer les résonateurs les uns par rapport aux autres, la fréquence des modes hybridés étant fonction des positions relatives desdits résonateurs ;
- la distance entre les résonateurs est comprise entre λ'/30 et λ'/3 où λ' est λa longueur d'onde associée à la pulsation ω'.

Par ailleurs, l'invention a également pour objet un dispositif de résonance magnétique nucléaire comportant au moins :
- un électroaimant adapté pour générer un champ magnétique permanent,
- un système d'antenne radiofréquence tel que décrit ci-dessus, adapté pour générer un champ magnétique radio fréquence ayant au moins une composante transverse au champ magnétique permanent.

Dans des modes de réalisation préférés du dispositif de résonance magnétique nucléaire selon l'invention, on peut éventuellement avoir recours en outre à l'une et/ou à l'autre des dispositions suivantes :
- le dispositif comporte en outre un élément conducteur passif non résonant adapté pour rendre plus homogène le champ magnétique radiofréquence ;
- le dispositif d'imagerie comprend en outre un système de bobines adapté pour créer des gradients de champs magnétiques s'ajoutant au champ magnétique permanent;
- le champ magnétique permanent est supérieur ou égal à 3T ;

D'autres caractéristiques et avantages de l'invention apparaîtront au cours de la description suivante de plusieurs de ses formes de réalisation, donnée à titre d'exemple non limitatif, en regard des dessins joints.

Sur les dessins :
- la figure 1 est un schéma de principe d'un dispositif d'imagerie IRM comportant un système d'antenne radiofréquence selon une forme de réalisation de l'invention,
- la figure 2 est un schéma bloc du dispositif d'antenne radiofréquence selon une forme de réalisation de l'invention,
- la figure 3 montre le système d'antenne radiofréquence du dispositif d'imagerie de la figure 1,
- la figure 4 montre une variante du système d'antenne radiofréquence dans le cas d'un système résonant à quatre résonateurs,
- les figures 5a, b, c, d sont la schématisation des quatre modes hybridés, dans le cas du système d'antenne de la figure 4,
- les figures 6 a et b sont les modélisations des directions du champ magnétique radiofréquence pour deux modes hybridés différents, dans le cas du système d'antenne de la figure 4,
- la figure 7 est la cartographie du champ magnétique au sein du système d'antenne radiofréquence de la figure 4,
- les figures 8 a et b sont des images IRM prises respectivement avec et sans résonateurs au sein de l'émetteur et/ou récepteur décrit à la figure 4,
- la figure 9 est un schéma d'un système d'antenne radiofréquence avec un diélectrique, dans une variante de l'invention.
- la figure 10 montre une autre variante du système d'antenne radiofréquence, comportant deux résonateurs,
- la figure 11 est un schéma du système d'antenne radiofréquence dans une variante comprenant quatre résonateurs incluant des éléments non résonants,

Sur les différentes figures, les mêmes références désignent des éléments identiques ou similaires.

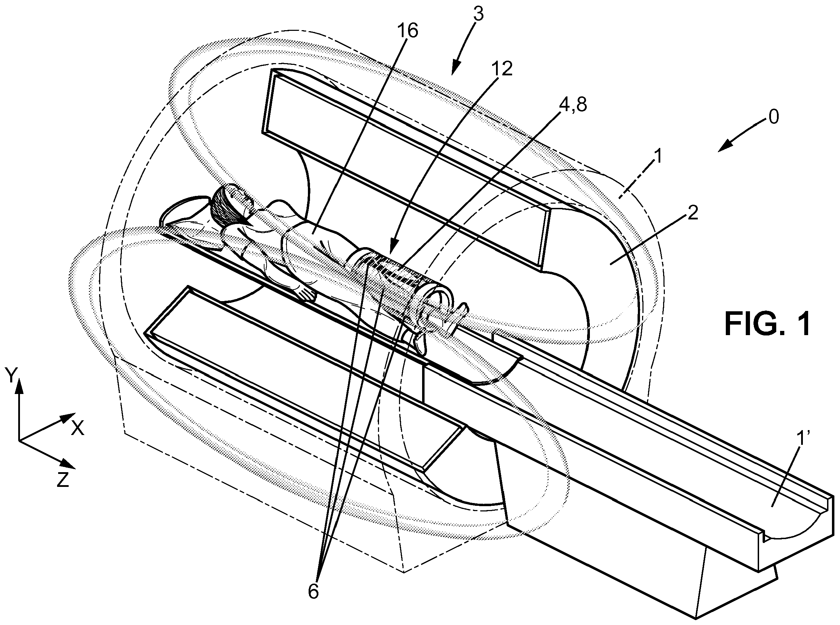

La figure 1 représente un dispositif de résonance magnétique nucléaire 0, comprenant un électroaimant 2 qui génère un champ magnétique permanent B0. Dans tout ce qui suivra on notera z un axe horizontal dans l'espace tel que représenté sur la figure 1, x étant un axe horizontal perpendiculaire à l'axe z et y un axe vertical. Les lignes du champ magnétique permanent B0 généré par l'électroaimant 2 bouclent entre l'intérieur et l'extérieur de l'électroaimant 2 comme représenté sur la figure 1, et le champ dans l'enceinte de l'électroaimant 2 est le long dudit axe z.

Le dispositif de résonance magnétique nucléaire 0 comprend également un dispositif d'antenne radiofréquence. Le dispositif d'antenne radiofréquence comprend un système d'antenne radiofréquence 3 générant des ondes de champ magnétique radiofréquence B1 via un émetteur radiofréquence 4, à la fréquence ω0, dite fréquence de Larmor des moments magnétiques des noyaux étudiés tels que définis au paragraphe suivant, qui est la fréquence de travail du dispositif d'antenne radiofréquence. Ces ondes sont générées au sein d'un système de résonateurs 6, le champ B1 étant transverse au champ magnétique permanent B0. Le système d'antenne radiofréquence 3 comprend également un récepteur radiofréquence 8. En variante le dispositif d'antenne radiofréquence peut être utilisé au sein du dispositif de résonance magnétique nucléaire uniquement à l'émission ou à la réception. Dans une autre variante l'émetteur radiofréquence 4 et le récepteur radiofréquence 8 peuvent être un seul et même élément. Le système d'antenne radiofréquence 3 inclus une électronique qui sera décrite dans la suite de la description et est connecté à une unité centrale pour former le dispositif d'antenne radiofréquence.

En proportion par rapport à un dispositif IRM, tel que représenté à la figure 1, le système d'antenne radiofréquence intégré au sein du dispositif IRM aura une amplitude de 30cm par exemple pour une enceinte IRM de un mètre de diamètre, ou plus généralement le système d'antenne radiofréquence pourra avoir une amplitude de l'ordre du tiers de l'amplitude du dispositif de résonance magnétique nucléaire.

Le principe général du dispositif de résonance magnétique nucléaire 0 reposant sur le principe de la résonance magnétique nucléaire, est de préalablement magnétiser les tissus par alignement des moments magnétiques des noyaux à l'aide du champ magnétique permanent B0 émis par l'électroaimant 2. Le champ magnétique radiofréquence B1 met en précession les moments magnétiques des noyaux à ladite fréquence de Larmor ω0. Cette fréquence de Larmor est déterminée par le champ magnétique permanent B0 de l'électroaimant. Elle est définie par la relation: ω0=γ.B0, γ étant le rapport gyromagnétique du noyau. La dynamique de retour à l'équilibre des moments magnétique des noyaux est enregistrée. Elle dépend de la nature des tissus biologiques étudiés. Ce principe général est bien connu en soi et ne sera pas décrit avec plus de détail ici.

Le dispositif de résonance magnétique nucléaire 0 comprend également un système de refroidissement à l'hélium 1 et un système 1' d'introduction du patient dans l'enceinte définie par l'électroaimant 2.

Le dispositif de résonance magnétique nucléaire peut être utilisé pour faire de la spectroscopie RMN ou de l'imagerie IRM.

Dans ce second cas, le dispositif de résonance magnétique nucléaire 0 comprend également un système de bobines 12 tel que représenté à la figure 1, permettant de créer des gradients de champs magnétiques s'ajoutant au champ magnétique permanent, utilisé pour localiser la tranche imagée. Les gradients de champs magnétiques créés par le système de bobines 12 permettent d'induire des fréquences de précession légèrement différentes en fonction de la position des noyaux dans ces gradients.

Le champ magnétique permanent B0 a par exemple une valeur comprise entre 1T et 20T. Pour le dispositif de résonance magnétique nucléaire 0 fonctionnant à 1.5T, la fréquence de Larmor est typiquement de 63MHz pour le moment des noyaux d'hydrogène. Pour le dispositif de résonance magnétique nucléaire 0 fonctionnant à 9.4T, la fréquence de Larmor est typiquement de 400MHz et le dispositif de résonance magnétique nucléaire 0 peut monter par exemple à 17T chez l'animal, comme champ de travail, ce qui correspond à une fréquence de Larmor de 730MHz. Le dispositif de résonance magnétique nucléaire 0 peut travailler à des champs magnétiques allant de façon générale de 3T à 30T. Dans un mode privilégié de réalisation, le champ magnétique permanent B0 sera supérieur ou égal à 3T.

L'émetteur 4 et/ou récepteur 8 radiofréquence est relié à un dispositif électronique de commande d'émission 9 et/ou réception 9', comportant générateurs de signaux radiofréquence, amplificateurs et par exemple une connexion électrique avec une source de courant. Le dispositif de commande est adapté pour faire émettre et/ou recevoir par ledit émetteur 4 et/ou récepteur 8 radiofréquence, des ondes radiofréquence B1 à la fréquence radio ω₀ dans un volume donné 13, dans le plan (x,y) par exemple, l'orientation du champ magnétique permanent B0 étant selon l'axe z.

Un système électronique d'adaptation d'impédance 28 permet d'adapter la fréquence de résonance du système d'antenne radiofréquence 3 sur ladite fréquence de Larmor ω0 de l'élément à imager. Un circuit électrique d'adaptation 30 présent sur l'alimentation du récepteur radiofréquence 8, comportant des composants passifs tels que des capacités en matériau amagnétique permet d'adapter la fréquence des ondes radiofréquence au dispositif de commande de réception 9'.

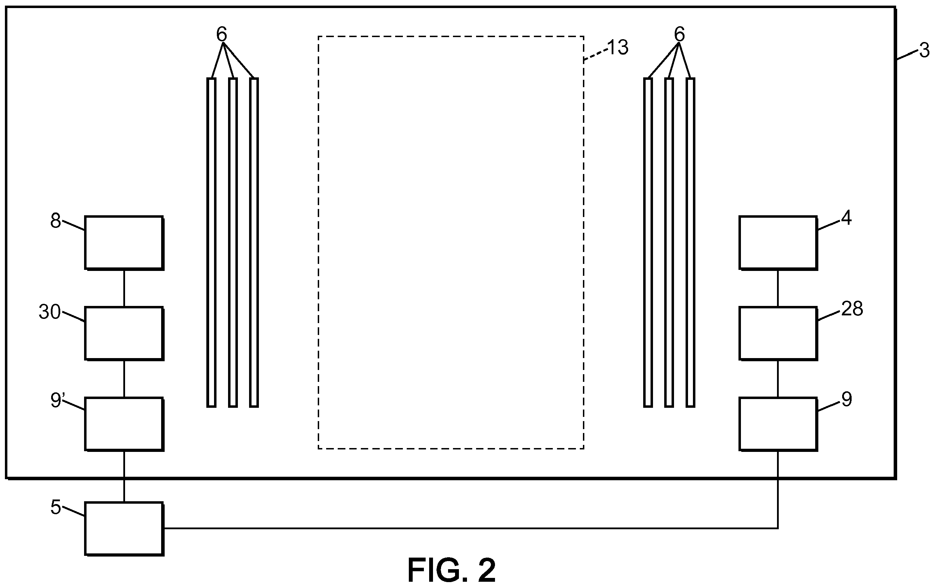

L'ensemble émetteur radiofréquence 4, système d'adaptation 28 et dispositif de commande d'émission 9 et/ou réception 9' constitue l'entrée du système d'antenne radiofréquence 3. Le récepteur radiofréquence 8, le circuit électrique d'adaptation 30 et le dispositif de commande de réception 9' constitue la sortie du système d'antenne radiofréquence 3. Cette entrée ainsi que cette sortie avec le système de résonateurs 6 constitue le système d'antenne radiofréquence 3. Le dispositif d'antenne radiofréquence est constitué de ce système d'antenne radiofréquence 3, ainsi que d'une unité centrale 5. Ce dispositif est schématisé par un diagramme bloc à la figure 2.

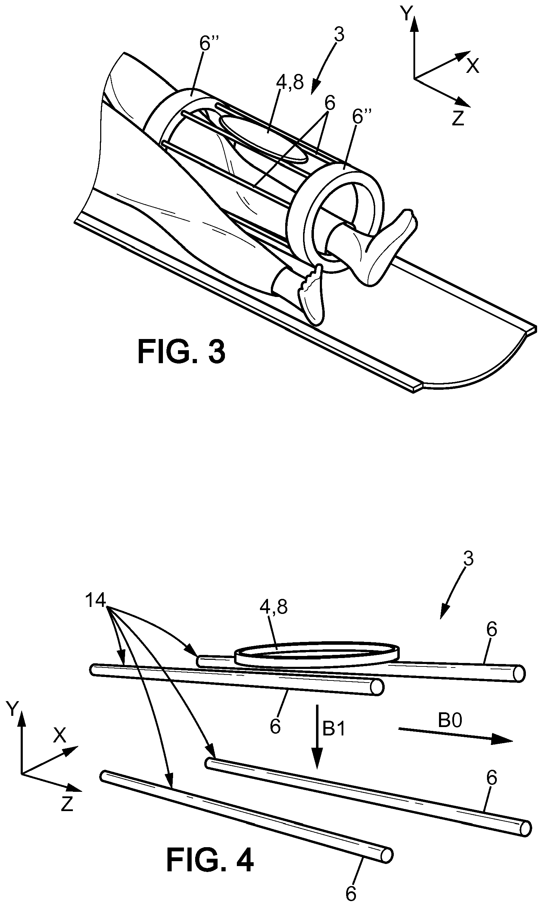

L'émetteur 4 et/ou récepteur 8 radiofréquence peut être par exemple une unique antenne magnétique comme représenté à la figure 3. Une telle antenne magnétique peut être par exemple une boucle d'axe y, contenue dans le plan (x,z). Cette boucle génère un champ magnétique radiofréquence B1 qui est le long de son axe y, et qui décroit par exemple en 1/r. Le diamètre de la boucle peut être par exemple de l'ordre de 3.5cm pour un dispositif IRM pour animal 7T. Le diamètre de la boucle est de l'ordre de 20cm à 30cm pour un dispositif IRM 7T pour humain. Les champs nécessaires pour la RMN sont plus faibles.

Le système d'antenne radiofréquence 3, tel que par exemple représenté à la figure 3, comprend aussi un système de résonateurs électromagnétiques. Le système de résonateurs comporte un ensemble de résonateurs électromagnétiques, chaque résonateur étant noté 6. Les résonateurs 6 sont adjacents solidarisés mécaniquement à un support, mais non solidarisés mécaniquement les uns aux autres et non connectés électriquement les uns aux autres. Le système de résonateurs électromagnétiques n'est pas non plus solidaire de l'émetteur 4 et/ou récepteur 8 radiofréquence. Dans un mode particulier de réalisation les résonateurs électromagnétiques 6 sont connectés mécaniquement de part et d'autre de l'enceinte résonante sur des bagues 6" comme illustré par la figure 3.

Dans un mode de réalisation, le système de résonateurs 6 est excité par l'émetteur 4 radiofréquence, qui peut être une unique antenne magnétique. Les ondes radiofréquence émises par le système peuvent être par exemple reçues par le récepteur 8 radiofréquence dans le cas où le système antenne radiofréquence est utilisé en émission et en réception. Le système antenne radiofréquence peut également être utilisé uniquement en émission ou en réception, la réception ou émission respectivement étant assurée par un autre dispositif tel qu'une « birdcage » par exemple. Dans un mode particulier de réalisation, le récepteur 8 radiofréquence pourra être par exemple une antenne magnétique qui est dans le plan (x,z) et les tiges résonantes, qui jouent le rôle de résonateurs électromagnétiques chacun noté 6, pourront être parallèles à l'axe z.

Les résonateurs électromagnétiques 6 sont isolés électriquement les uns des autres et de l'émetteur 4 et/ou récepteur 8 radiofréquence. L'émetteur 4 et/ou récepteur 8 radiofréquence peut être fixe par exemple et le système de résonateurs 6 peut être déplacé pour choisir la zone à imager, de manière notamment à imager une zone qui n'est pas en vis-à-vis de l'antenne, par exemple.
Les résonateurs électromagnétiques 6 sont hybridés entre eux. Pour N résonateurs électromagnétiques 6 hybridés le système de résonateurs est décrit par N modes hybrides. On peut noter ω la fréquence à laquelle résonne le résonateur considéré seul. Chaque mode hybridé a une fréquence propre et correspond à une disposition propre des lignes de champ magnétique radiofréquence B1. Ces modes hybridés s'accompagnent d'une exaltation du champ magnétique radiofréquence B1 ce qui permet d'améliorer le rapport signal sur bruit. Parmi les N modes tous ne correspondent pas à des champs magnétiques constructifs dans l'enceinte définie par le système de résonateurs. Un ou plusieurs de ces modes hybrides, correspondant à une cartographie des lignes de champ magnétique, peuvent être excités sélectivement. Pour un dispositif à résonance magnétique nucléaire utilisé à la fréquence ω0, notons ω' la fréquence de résonance du mode hybridé de fréquence la plus proche de ω0. Comme décrit par la suite, le système de résonateurs 6 pourra être modifié en géométrie afin que ω' soit rendu plus proche de ω0, la fréquence de travail du dispositif de résonance magnétique nucléaire.
Les résonateurs électromagnétiques 6 peuvent être par exemple des résonateurs qui présentent au moins une résonance principalement excitée par le champ électrique tels que des tiges métalliques conductrices rectilignes parallèles. De tels résonateurs seront nommés résonateurs électriques dans la suite de la description. Les tiges peuvent être par exemple recouvertes d'un matériau isolant. Les résonateurs électriques 6 qui sont en matériau amagnétique peuvent être par exemple en matériau non-ferreux tels que le cuivre pur, le laiton, l'aluminium.
Un résonateur électrique 6 peut être par exemple une tige qui résonne autour de ω0/2. Le résonateur électrique 6 est donc dans ce cas de dimension comparable à la demi-longueur d'onde. Le nombre de résonateurs électriques 6 est variable.

Dans un mode particulier de réalisation, quatre tiges électriquement résonantes 6 peuvent être hybridées comme représenté à la figure 4. Le système résonant à quatre tiges 14 peut être décrit par quatre modes hybrides, avec quatre fréquences de résonance ω différentes. Les quatre tiges résonantes 6 peuvent être par exemple agencées circulairement autour d'un axe parallèle à z.
Dans le cas où l'émetteur 4 radiofréquence est une boucle dans le plan (x,z), les tiges résonantes 6 sont peu éloignées de la boucle, pour un bon fonctionnement du système c'est-à-dire pour que le système résonant 14 attrape bien les lignes de champ magnétique radiofréquence B1 issues de la boucle. La distance selon l'axe z qui sépare les tiges résonantes 6 de la boucle peut être par exemple de l'ordre du rayon de la boucle. La distance entre les tiges résonantes est variable. La distance entre les tiges résonantes peut être par exemple de l'ordre du diamètre de la boucle. Ces dimensions sont données à titre indicatif et peuvent être différentes dans d'autres modes de réalisation.

Les résonateurs 6 peuvent être par exemple séparés d'une distance comprise entre λ'/30 et λ'/3 avec λ' la longueur d'onde associée à la pulsation ω' ladite fréquence de mode hybridé proche de ω0.

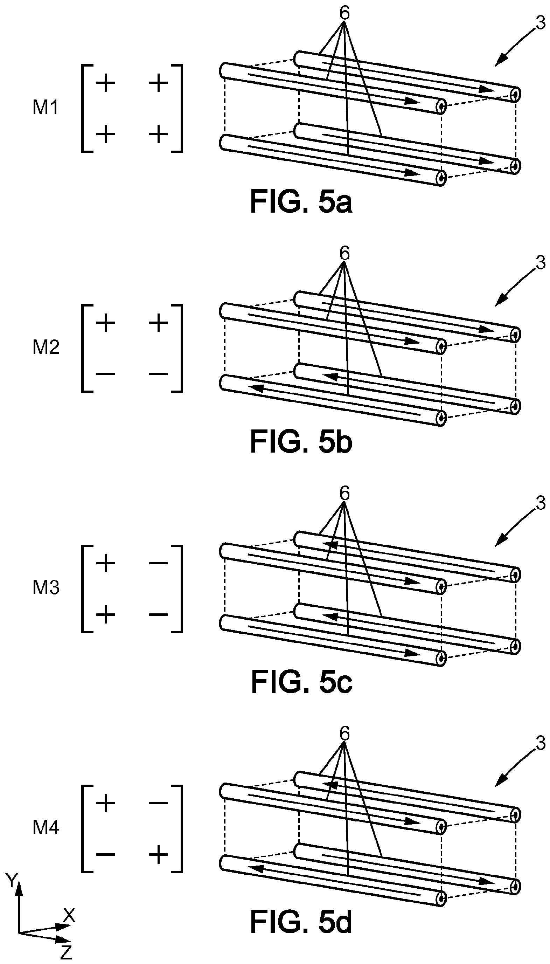

Les tiges électriquement résonantes 6 sont parcourues par des courants qui peuvent être parallèles ou anti-parallèles pour deux tiges résonantes 6 adjacentes : il y a un phénomène de couplage électromagnétique entre les quatre tiges résonantes 6. Chaque tige peut être assimilée à un dipôle et deux dipôles adjacents sont hybridés symétriquement ou anti-symétriquement. Chaque mode hybride du système résonant à quatre tiges 14 correspond à une configuration particulière des sens des courants dans chacun des quatre résonateurs électromagnétiques 6 comme représenté sur la figure 5.

Le système résonant à quatre tiges 14 peut alors être décrit par quatre modes hybrides. Le champ magnétique radiofréquence créé par la boucle et parallèle à y est exalté par l'excitation d'un de ces modes du système résonant à quatre tiges 14: la distribution spatiale du champ magnétique radiofréquence B1 émis par l'émetteur 4 radiofréquence est modifiée.

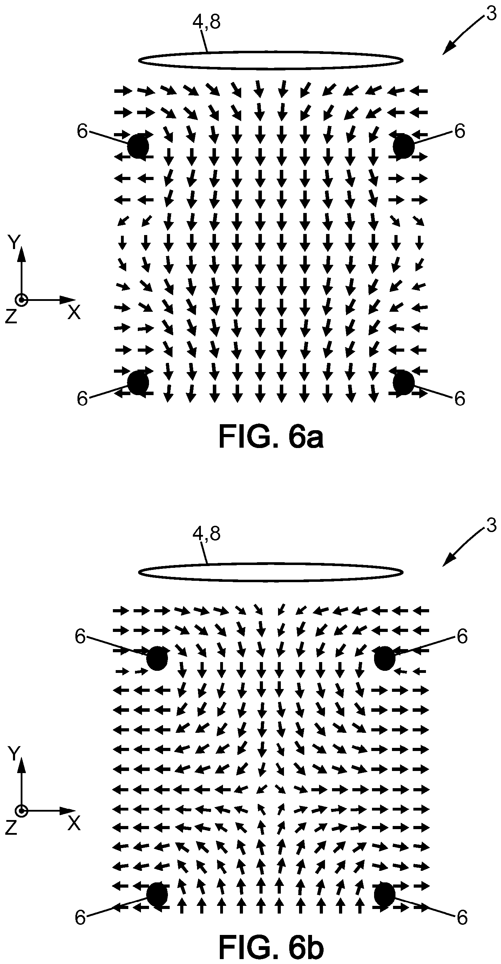

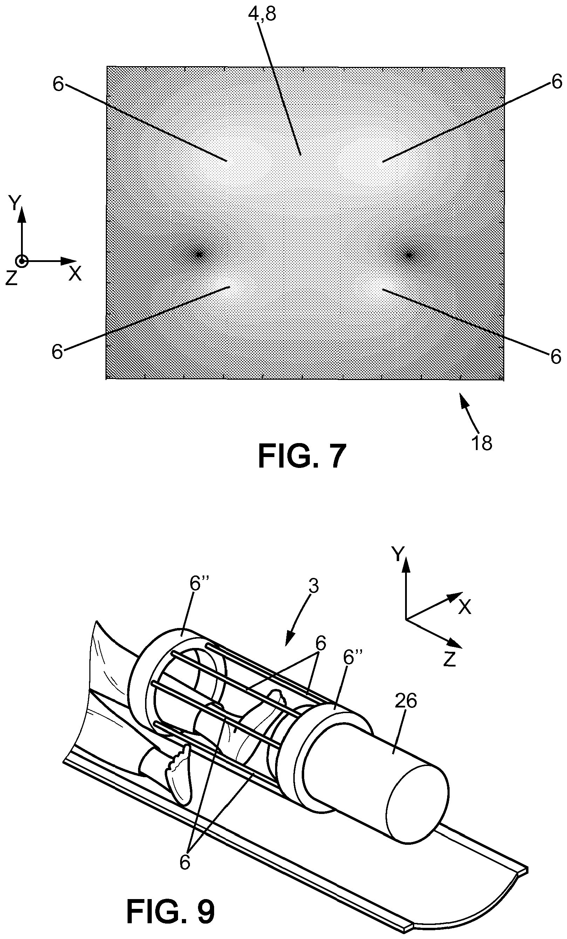

Parmi ces quatre modes hybrides, les modes correspondants à des interférences constructives pour le champ magnétique radiofréquence B1 peuvent être par exemple sélectionnés. Plus précisément dans le cas d'un système résonant à quatre tiges 14, les modes hybrides M1 et M2 obtenus ne respectent pas la symétrie du système résonant 14. Les modes hybrides M2 et M3 génèrent un champ magnétique radiofréquence homogène au centre du système résonant à quatre tiges 14. Du fait de la symétrie, ces deux modes résonnent à la même fréquence. Le quatrième mode hybride M4 correspond à une interférence destructive qui donne un champ magnétique radiofréquence B1 nul au centre. La symétrie horizontale du système résonant 14 étant rompue par la boucle d'axe y, seuls les modes hybrides M3 et M4 sont excitables. La figure 6 représente la distribution du champ magnétique radiofréquence (le champ magnétique radiofréquence est symbolisé par une flèche) dans l'enceinte du système résonant 14. Si seul le mode hybride M3 est par exemple excité, ce mode a une symétrie axiale autour de l'axe parallèle à y de la boucle, ce qui donne lieu à des interférences constructives au centre du système résonant 14. Le mode excité du système résonant 14 perturbe alors la cartographie du champ magnétique radiofréquence B1 émis par la boucle, et le champ magnétique radiofréquence B1 dans l'enceinte du système résonant 14 est à distribution volumique autour de y et quasi homogène tel que représenté à la figure 6. La figure 7 donne la cartographie 18 de champ magnétique B1 pour un système d'antenne radiofréquence 3 dans le cas particulier de ce mode de réalisation à une seule boucle jouant le rôle d' émetteur et/ou récepteur radiofréquence d'axe y.

L'excitation des modes hybridés est corrélée à la distance entre l'émetteur 4 et/ou récepteur 8 radiofréquence et le système de résonateurs. Les modes hybridés sont également corrélés à la dimension de l'émetteur 4 et/ou récepteur 8 radiofréquence. Dans le cas du système résonant à quatre tiges 14, les résonateurs 6 sont séparés pour libérer une importante zone d'imagerie. La distance séparant les deux plans contenant les tiges résonantes 6 deux à deux, et parallèles au plan (x, z), est courte pour obtenir un champ magnétique B1 sur les tiges résonantes 6 du niveau inférieur d'amplitude suffisante pour permettre un phénomène d'exaltation du champ magnétique B1 dans cette zone. Pour une IRM animal 7T par exemple, la distance entre tiges adjacentes résonantes 6 est de l'ordre de 2.5cm par exemple.

Au niveau applicatif, comme évoqué précédemment, le système d'antenne radiofréquence sera souvent privilégié pour la réception, alors que l'émission pourra être assurée par une birdcage, notamment pour les avantages de gain en réception acquis lors de l'utilisation du système d'antenne radiofréquence. Dans un mode particulier de réalisation, l'émetteur 4 sera une « birdcage » et la réception utilisera un système d'antenne radiofréquence incluant un ensemble de résonateurs 6 et un récepteur radiofréquence 8. Le récepteur radiofréquence 8 reçoit des ondes de champ magnétique radiofréquence captées dans l'enceinte définie par le système de résonateurs, à la fréquence ω0. Le récepteur magnétique radiofréquence 8 peut être par exemple pour ce mode de réalisation une antenne magnétique simple. Le récepteur peut être en variante l'un quelconque de ceux cités précédemment, par exemple.
Dans un autre mode de réalisation, le récepteur magnétique radiofréquence 8 peut être par exemple identique à l'émetteur radiofréquence 4.

Lors de l'utilisation d'un dispositif de résonance magnétique nucléaire 0, la fréquence de Larmor du noyau à imager est connue à priori. On image généralement le noyau d'hydrogène (le proton), bien que d'autres noyaux puissent être utilisés. Il peut donc être intéressant pour l'IRM et nécessaire pour la RMN de pouvoir ajuster la fréquence de résonance du dispositif de résonance magnétique nucléaire aux fréquences de Larmor des noyaux de la structure à imager, fréquence de résonance qui peut évoluer en fonction des champs auxquels le dispositif de résonance magnétique nucléaire travaille.

La fréquence des modes hybridés des résonateurs 6 est susceptible d'être différente en fonction de la charge placée au sein de l'enceinte définie par le système de résonateurs. Il peut être donc nécessaire de pouvoir faire des ajustements en fréquence des résonateurs 6 hybridés.

Le souhait de pouvoir détecter d'autres éléments liés à d'autres fréquences de Larmor ω0 est également un argument clef pour faire évoluer les dispositifs actuels de résonance magnétique nucléaire.

Le système d'antenne radiofréquence 3 excite les moments magnétiques des noyaux sur le principe de la Résonance Magnétique Nucléaire, à la fréquence à laquelle doit résonner le système d'antenne radiofréquence 3 pour mettre en résonance les moments magnétiques des noyaux à imager. Le système de résonateurs est conçu pour que ses dimensions soient celles permettant d'obtenir un mode hybridé de champ constructif à la fréquence de Larmor.

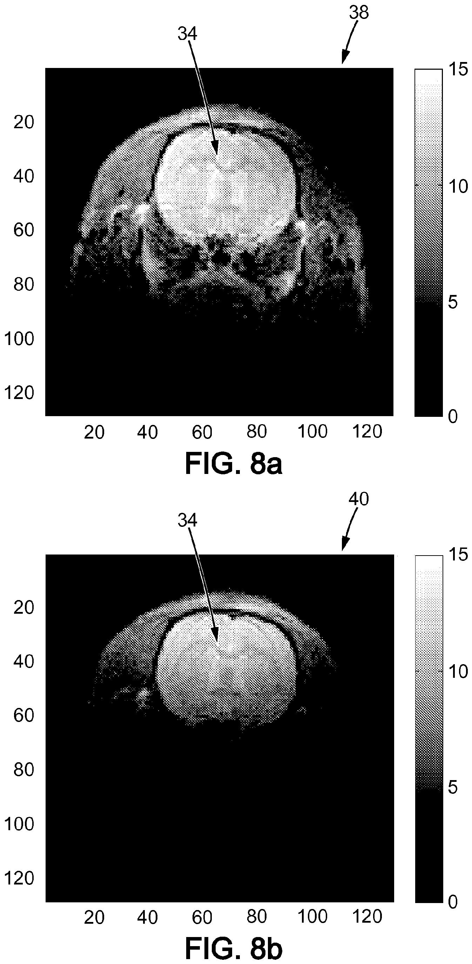

Grâce à l'utilisation de systèmes résonants, le rapport signal sur bruit du dispositif de résonance magnétique nucléaire est augmenté par exemple d'au moins 100% et une augmentation de la profondeur de pénétration et une augmentation de la zone d'éclairement longitudinale sont observées par rapport aux dispositifs IRM existants. Les performances du système décrit dans l'invention sont mises en évidence à la figure 8. La figure 8a est une image IRM 38 de la zone à imager 34 d'une tête de rat 16, prise lorsque le système d'antenne radiofréquence 3 du dispositif IRM ne comprend pas de système de résonateurs. La figure 8b est une image IRM 40 de la zone à imager 34 d'un sujet 16, prise lorsque le système d'antenne radiofréquence 3 du dispositif IRM comprend un système de résonateurs.

Dans un mode particulier de réalisation, la fréquence de résonance du système défini par l'ensemble des résonateurs 6 peut être ajustée mécaniquement, en jouant sur la longueur du résonateur électromagnétique 6. Un dispositif interne pour régler la longueur des tiges peut être intégré au système par exemple. Il peut s'agir d'un moteur permettant de modifier la longueur de tiges par exemple télescopiques. Dans un autre mode de réalisation la fréquence de résonance du système de résonateurs peut être ajustée mécaniquement par l'intégration d'un élément solide diélectrique 26 d'indice élevé tel que le plexiglas (indice supérieur à 4), comme représenté à la figure 9. En variante la fréquence de résonance du système de résonateurs peut être ajustée mécaniquement en modifiant les positions relatives des résonateurs électromagnétiques 6.

La fréquence de résonance du système défini par l'ensemble des résonateurs 6 peut être également ajustée électriquement, par l'utilisation d'éléments passifs tels que des capacités notamment.

Il est par exemple nécessaire de pouvoir accorder et désaccorder facilement le système de résonateurs 6, dans le cas où les antennes d'émission 4 et de réception 8 sont différentes par exemple, de manière à ne pas induire lors de l'émission de signal dans l'antenne de réception.

En variante plusieurs noyaux avec différentes fréquences de résonance peuvent être imagés pendant la même manipulation, soit successivement en ajustant la fréquence du système de résonateurs à la fréquence du noyau à imager, soit simultanément en faisant coexister deux modes hybrides à deux fréquences de résonance différentes dans l'enceinte du système d'antenne radiofréquence 3.

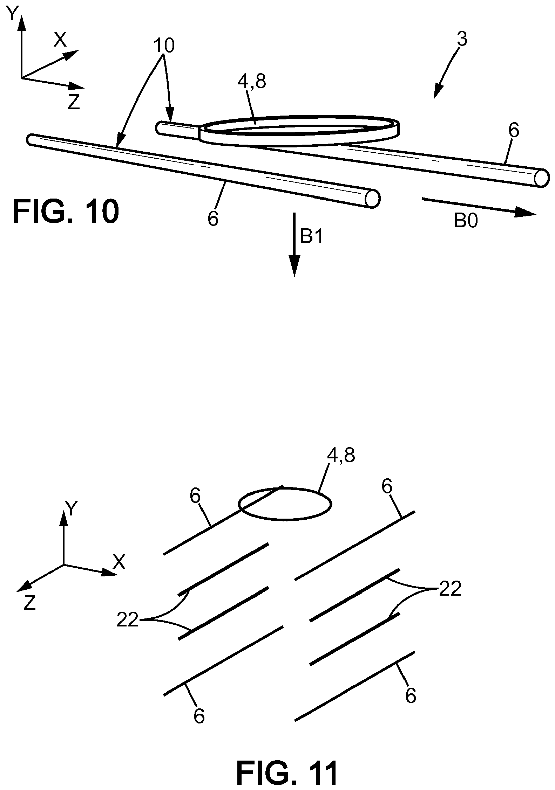

Dans un mode particulier de réalisation au lieu de quatre tiges résonantes, seulement deux tiges résonantes peuvent être hybridées tel que représenté à la figure 10. Le système résonant à deux tiges 10 peut être excité par un émetteur 4 et/ou récepteur 8 radiofréquence qui peut être une boucle contenue dans le plan (x,z). Les deux tiges résonantes 6 sont parcourues par des courants qui sont dans le même sens ou dans des sens opposés. Le système résonant à deux tiges 10 peut alors être décrit par deux modes hybrides.

Dans un autre mode particulier de réalisation l'émetteur 4 et/ou récepteur 8 radiofréquence peut être un dipôle électrique, non adapté, d'axe z. En variante l'émetteur 4 et/ou récepteur 8 radiofréquence peut être un ensemble d'antennes magnétiques pour obtenir un champ magnétique plus homogène. Il peut s'agir par exemple de deux antennes magnétiques placées en quadrature telles que deux boucles placées dans les plans (x,z) et (y,z). Le champ magnétique B1 tourne alors à la fréquence de Larmor dans le plan (x,y). Si le système résonant à quatre tiges 14 est excité par un émetteur 4 radiofréquence comprenant deux boucles placées en quadrature, les modes hybrides M2 et M3 de même fréquence de résonance peuvent être excités simultanément. Cette solution répond à des problématiques de vitesse d'acquisition et de performances du dispositif IRM 0.

Dans une autre variante l'ensemble d'antennes magnétiques peut comprendre deux boucles contenues dans des plans parallèles au plan (x,z), de part et d'autre du plan (x,z). L'amplitude du champ magnétique B1 peut alors être par exemple augmentée.

Dans un mode particulier de réalisation, le nombre de résonateurs électromagnétiques 6 est N>4. Des zéros de champ magnétique B1 supplémentaires apparaissent dans la cartographie du champ magnétique B1. En variante le résonateur 6 peut être une tige métallique avec une forme de boucle par exemple ou de créneau, ou de bobine.

En variante on introduit d'autres éléments non résonants dans l'enceinte du système de résonateurs, pour étendre et améliorer l'homogénéité de champ magnétique volumique B1 dans l'enceinte du système de résonateurs. Dans le cas particulier d'un système résonant à quatre tiges 14, des tiges supplémentaires plus courtes 22, également parallèles à z sont ajoutées au système résonant 14 tel que représenté à la figure 11. Elles sont parcourues par des courants qui perturbent la cartographie du champ magnétique B1 au sein du système d'antenne radiofréquence 3 en portant le champ magnétique B1 plus loin sur y, mais sans que les tiges 22 ici introduites ne participent au phénomène d'hybridation du système résonant 14. Le champ magnétique B1 est homogène sur une zone assez étendue au centre du système résonant à quatre tiges 14 pour le mode hybride de champ magnétique constructif.

Le récepteur magnétique radiofréquence 8 peut être identique ou différent de l'émetteur radiofréquence 4.

Lorsque la zone à imager 34 devient étendue, dans le cas d'un 7T humain par exemple, les variations de champ magnétique B1 dans la zone à imager 34 ne sont plus négligeables. Les zéros de champ magnétique B1 dans cette zone 34 sont nombreux. Dans un mode particulier de réalisation, plusieurs modes hybrides du système de résonateurs peuvent être excités à la fois ou successivement par ajustement électrique ou mécanique, et les images obtenues pour chacun des modes sont recoupées. Par exemple, dans le cas du système résonant à quatre tiges 14, les modes hybrides M3 et M4 sont excités en même temps. La cartographie en champ du mode hybride M4 comporte un zéro de champ magnétique au centre. En modifiant la longueur des deux tiges résonantes du bas, le zéro de champ magnétique B1 est déplacé et les images obtenues pour ces deux modes hybrides connus sont recoupées pour augmenter la définition. En variante les images obtenues pour les différents modes hybrides peuvent être interprétées au regard de la cartographie de champs magnétique B1 de chacun des modes hybrides, leurs zones d'homogénéité et leurs nœuds de champ magnétique. En variante les images peuvent être obtenues en travaillant avec plusieurs modes hybrides, cartographiés, dont la somme donne un champ magnétique B1 homogène. Dans un mode particulier de réalisation utilisant un ensemble d'antennes magnétiques comme émetteur radiofréquence 4, le réseau multivoies envoie des impulsions radiofréquence différentes sur chaque voie de manière à ce que le champ magnétique B1 émis par l'ensemble d'antennes magnétiques donne un angle de bascule homogène au total. Le champ magnétique B1 est alors assimilé à un champ magnétique homogène dans la zone à imager 34. En variante différentes images peuvent être obtenues successivement en déplaçant l'objet à imager relativement à la cartographie du champ magnétique B1 du système de résonateurs pour le mode hybride sélectionné, puis l'image globale est obtenue en sommant ces images au prorata de leurs contributions.

## Revendications

1. Système d'antenne radiofréquence (3) pour un dispositif de résonance magnétique nucléaire, comprenant au moins un émetteur (4) et/ou récepteur (8) radiofréquence relié à un dispositif de commande d'émission (9) et/ou réception (9') adapté pour faire émettre et/ou recevoir par ladite antenne radiofréquence, des ondes radiofréquence à une fréquence radio ω0 dans un volume donné (13), et des résonateurs (6), **caractérisé en ce que lesdits résonateurs (6)** sont hybridés électromagnétiquement entre eux et agencés afin d'obtenir un mode hybridé ayant une fréquence de résonance **ω'** proche de **ω**0 permettant d'exalter un champ magnétique radiofréquence généré par le système d'antenne radiofréquence, couplés à l'émetteur (4) et/ou récepteur (8) radiofréquence et isolés électriquement les uns des autres et de l' émetteur (4) et/ou récepteur (8) radiofréquence.

2. Système selon la revendication 1, dans lequel les résonateurs (6) sont au nombre de N et présentent N mode hybridés, le système d'antenne radiofréquence (3) comportant en outre des moyens d'excitation de mode pour exciter sélectivement lesdits modes hybridés.

3. Système selon la revendication 2, dans lequel lesdits moyens d'excitation de mode sont adaptés pour exciter simultanément plusieurs modes hybridés.

4. Système selon l'une quelconque des revendications 1 à 3, dans lequel les résonateurs (6) comportent des résonateurs qui présentent au moins une résonance principalement excitée par le champ électrique.

5. Système selon l'une quelconque des revendications 1 à 4, dans lequel les résonateurs (6) sont des tiges résonantes, parallèles, disposées autour du volume donné (13) et réalisées en un matériau amagnétique et conducteur de l'électricité.

6. Système selon la revendication 5, dans lequel les tiges résonantes sont agencées à égale distance d'un axe central.

7. Système selon l'une quelconque des revendications 1 à 6, dans lequel l'émetteur (4) et/ou récepteur (8) radiofréquence comporte une antenne radiofréquence choisie parmi une boucle et un dipôle électrique non adapté.

8. Système selon l'une quelconque des revendications 1 à 7, dans lequel l'émetteur (4) et/ou récepteur (8) radiofréquence comporte plusieurs antennes radiofréquences.

9. Système selon l'une quelconque des revendications 1 à 8 comportant en outre un élément solide diélectrique (26) d'indice élevé disposé au moins partiellement entre les résonateurs.

10. Système selon l'une quelconque des revendications 1 à 9, comportant en outre au moins un dispositif de déplacement pour déplacer les résonateurs (6) les uns par rapport aux autres, la fréquence des modes hybridés étant fonction des positions relatives desdits résonateurs (6).

11. Système selon la revendication 5 et l'une quelconque des revendications 6 à 10, dans lequel les tiges résonantes ont une longueur réglable, comprenant en outre au moins un dispositif interne pour régler la longueur des tiges, la fréquence de résonance des tiges résonantes étant fonction de ladite longueur.

12. Système selon l'une quelconque des revendications 1 à 11, pour lequel la distance entre les résonateurs est comprise entre λ'/30 et λ'/3 où λ' est la longueur d'onde associée à la pulsation ω'.

13. Dispositif de résonance magnétique nucléaire comportant au moins :
- un électroaimant (2) adapté pour générer un champ magnétique permanent,
- un système d'antennes radiofréquence (3) selon l'une quelconque des revendications précédentes, adapté pour générer un champ magnétique radio fréquence ayant au moins une composante transverse au champ magnétique permanent.

14. Dispositif selon la revendication 13, comportant en outre au moins un élément conducteur passif non résonant (22) adapté pour rendre plus homogène le champ magnétique radiofréquence.

15. Dispositif de résonance magnétique nucléaire selon l'une quelconque des revendications 13 et 14, comprenant en outre un système de bobines (12) adapté pour créer des gradients de champs magnétiques s'ajoutant au champ magnétique permanent.

16. Dispositif selon l'une quelconque des revendications 12 et 13, dans lequel le champ magnétique permanent est supérieur ou égal à 3T.

## Patentansprüche

1. Hochfrequenz-Antennensystem (3) für eine Kernspinresonanzvorrichtung, umfassend mindestens einen Hochfrequenz-Sender (4) und/oder -Empfänger (8), der mit einer Sende- (9) und/oder Empfangssteuervorrichtung (9') verbunden ist, die geeignet ist zu veranlassen, dass die Hochfrequenzantenne Hochfrequenzwellen mit einer Hochfrequenz ω0 in einem bestimmten Volumen (13) sendet und/oder empfängt, und Resonatoren (6), **dadurch gekennzeichnet, dass** die Resonatoren (6) untereinander elektromagnetisch hybridisiert und eingerichtet, um einen Hybridbetrieb mit einer Resonanzfrequenz w' nahe ω0 zu erhalten, der erlaubt, ein von dem Hochfrequenz-Antennensystem erzeugtes Hochfrequenzmagnetfeld anzuregen, an den Hochfrequenz-Sender (4) und/oder -Empfänger (8) gekoppelt und voneinander und vom Hochfrequenz-Sender (4) und/oder -Empfänger (8) elektrisch isoliert sind.

2. System nach Anspruch 1, wobei die Resonatoren (6) in der Anzahl von N vorliegen und N Hybridbetriebe aufweisen, wobei das Hochfrequenz-Antennensystem (3) ferner Betriebserregungsmittel aufweist, um die Hybridbetriebe selektiv zu erregen.

3. System nach Anspruch 2, wobei die Betriebserregungsmittel zum gleichzeitigen Erregen mehrerer Hybridbetriebe geeignet sind.

4. System nach einem der Ansprüche 1 bis 3, wobei die Resonatoren (6) Resonatoren aufweisen, die mindestens eine hauptsächlich von dem elektrischen Feld erregte Resonanz aufweisen.

5. System nach einem der Ansprüche 1 bis 4, wobei die Resonatoren (6) parallele Resonanzstäbe sind, die um ein bestimmtes Volumen (13) angeordnet und aus einem magnetischen und stromleitenden Material hergestellt sind.

6. System nach Anspruch 5, wobei die Resonanzstäbe in gleichem Abstand von einer zentralen Achse angeordnet sind.

7. System nach einem der Ansprüche 1 bis 6, wobei der Hochfrequenz-Sender (4) und/oder -Empfänger (8) eine Hochfrequenzantenne aufweist, die aus einer Schleife und einem nicht angepassten elektrischen Dipol ausgewählt ist.

8. System nach einem der Ansprüche 1 bis 7, wobei der Hochfrequenz-Sender (4) und/oder -Empfänger (8) mehrere Hochfrequenzantennen aufweist.

9. System nach einem der Ansprüche 1 bis 8, aufweisend ferner ein dielektrisches Feststoffelement (26) mit hohem Index, das mindestens zum Teil zwischen den Resonatoren angeordnet ist.

10. System nach einem der Ansprüche 1 bis 9, aufweisend ferner mindestens eine Verlagerungsvorrichtung zum Verlagern der Resonatoren (6) im Verhältnis zueinander, wobei die Frequenz der Hybridbetriebe von den relativen Positionen der Resonatoren (6) abhängt.

11. System nach Anspruch 5 und einem der Ansprüche 6 bis 10, wobei die Resonanzstäbe eine einstellbare Länge haben, umfassend ferner mindestens eine innere Vorrichtung zum Einstellen der Länge der Stäbe, wobei die Resonanzfrequenz der Resonanzstäbe von der Länge abhängt.

12. System nach einem der Ansprüche 1 bis 11, wobei der Abstand zwischen den Resonatoren zwischen λ'/30 und λ'/3 beträgt, wobei λ' die der Pulsation ω' zugeordnete Wellenlänge ist.

13. Kernspinresonanzvorrichtung, aufweisend mindestens:
- einen Elektromagneten (2), der zum Erzeugen eines Dauermagnetfelds geeignet ist,
- ein Hochfrequenz-Antennensystem (3) nach einem der vorangehenden Ansprüche, das zum Erzeugen eines Hochfrequenz-Magnetfelds geeignet ist, das mindestens eine zum Dauermagnetfeld transversale Komponente hat.

14. Vorrichtung nach Anspruch 13, aufweisend ferner mindestens ein nicht resonierendes Passivleiterelement (22), das geeignet ist, das Hochfrequenz-Magnetfeld gleichmäßiger zu gestalten.

15. Kernspinresonanzvorrichtung nach einem der Ansprüche 13 und 14, umfassend ferner ein Spulensystem (12), das zum Bilden der Magnetfeldgradienten geeignet ist, die dem Dauermagnetfeld hinzugefügt werden.

16. Vorrichtung nach einem der Ansprüche 12 und 13, wobei das Dauermagnetfeld größer oder gleich 3T ist.

## Claims

1. A radiofrequency antenna system (3) for a nuclear magnetic resonance device, comprising at least one radiofrequency transmitter (4) and/or receiver (8) connected to a transmission (9) and/or reception (9') control device suitable for transmitting and/or receiving, via said radiofrequency antenna, radiofrequency waves at a radio frequency ω0 in a given volume (13), and resonators (6), **characterized in that said resonators (6)** are electromagnetically hybridized amongst themselves and arranged so as to obtain a hybridized mode having a resonance frequency ω' close to ω0 making it possible to excite a radiofrequency magnetic field generated by the radiofrequency antenna system, coupled with the radiofrequency transmitter (4) and/or receiver (8) and electrically insulated from one another and from the radiofrequency transmitter (4) and/or receiver (8).

2. The system according to claim 1, wherein there are N resonators (6) having N hybridized modes, the radiofrequency antenna system (3) further comprising mode excitation means for selectively exciting said hybridized modes.

3. The system according to claim 2, wherein said mode excitation means are suitable for exciting several hybridized modes at once.

4. The system according to any one of claims 1 to 3, wherein the resonators (6) comprise resonators that have at least one resonance primarily excited by the electric field.

5. The system according to any one of claims 1 to 4, wherein the resonators (6) are parallel resonant rods, arranged around the given volume (13) and made from a nonmagnetic and electrically conductive material.

6. The system according to claim 5, wherein the resonant rods are arranged equidistantly from a central axis.

7. The system according to any one of claims 1 to 6, wherein the radiofrequency transmitter (4) and/or receiver (8) comprises a radiofrequency antenna chosen from a loop and a non-adapted electric dipole.

8. The system according to any one of claims 1 to 7, wherein the radiofrequency transmitter (4) and/or receiver (8) comprises several radiofrequency antennas.

9. The system according to any one of claims 1 to 8, further comprising a solid dielectric element (26) of high index arranged at least partially between the resonators.

10. The system according to any one of claims 1 to 9, further comprising at least one movement device for moving the resonators (6) relative to one another, the frequency of the hybridized modes being a function of the relative positions of said resonators (6).

11. The system according to claim 5 and any one of claims 6 to 10, wherein the resonant rods have an adjustable length, further comprising at least one internal device for adjusting the length of the rods, the resonance frequency of the resonant rods being a function of said length.

12. The system according to any one of claims 1 to 11, wherein the distance between the resonators is between λ'/30 and λ'/3, where λ' is the wavelength associated with the angular frequency ω'.

13. A nuclear magnetic resonance device, comprising at least:
- an electromagnet (2) suitable for generating a permanent magnetic field,
- a system of radiofrequency antennas (3) according to any one of the preceding claims, suitable for generating a radiofrequency magnetic field having at least one component transverse to the permanent magnetic field.

14. The device according to claim 13, further comprising at least one non-resonant passive conductive element (22) suitable for making the radiofrequency magnetic field more homogeneous.

15. The nuclear magnetic resonance device according to any one of claims 13 and 14, further comprising a system of coils (12) suitable for creating magnetic field gradients added to the permanent magnetic field.

16. The device according to any one of claims 12 and 13, wherein the permanent magnetic field is greater than or equal to 3T.
